# EUROPEAN PATENT SPECIFICATION

(11) **EP 2 384 105 B1**
(45) Date of publication and mention of the grant of the patent: **12.08.2015**
(21) Application number: 10161279.4
(22) Date of filing: 28.04.2010
(51) Int. Cl.: H05K 5/00

(54) **COUPLING STRUCTURE FOR A SHELL**
VERBINDUNGSANORDNUNG FUER EIN GEHAEUSE
STRUCTURE DE COUPLAGE SUR UN BOITIER

(43) Date of publication of application: 02.11.2011
(73) Proprietor: Giga-Byte Technology Co., Ltd., New Taipei City 231 (TW)
(72) Inventor: Huang, Chun-Tao, 231, Hsin Tien, Taipei County (TW)
(74) Representative: Schwerbrock, Florian

(56) References cited:
- EP-A1- 0 930 813
- US-B1- 6 444 904

## Description

### BACKGROUND OF THE INVENTION

### 1. Field of the Invention

The present invention relates to a coupling structure, more particularly to a coupling structure for coupling first and second shell halves in order to form a shell or shell body.

### 2. Description of the Prior Art

Due to rapid advance in the electronic technology and due to habits of the electronic users, it is in the trend to minimize the dimension of the electronic devices. In many sophisticated electronics field, even a target to reduce a single centimeter in size is a challenging issue for the circuit design engineer. Therefore, to alter the product design of a shell to increase an internal circuit receiving space, undoubtedly permits flexible use of the circuit receiving space.

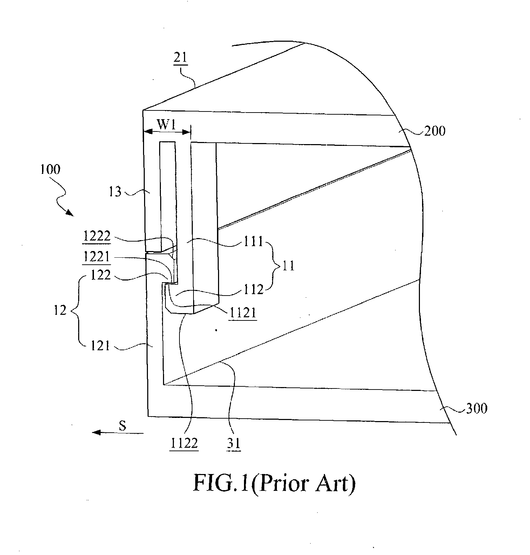

Referring to Figure 1, one embodiment of a conventional coupling structure 100 is disposed between a first shell half 200 and a second shell half 300 for coupling the same into a shell, and includes an upper hook 11, a lower hook 12 and a top post 13. The first and second shell halves 200, 300 are juxtaposed to each other. The first shell half 200 has a first side 21. The upper hook 11 includes a resilient section 111 projecting perpendicularly and downwardly from the first side 21 of the first shell half 200 toward the second shell half 300 and an engagement section 112 projecting transversely from the resilient section 111 along a detachment direction S.

The second shell half 300 has a first side 31. The lower hook 12 includes a resilient section 121 projecting perpendicularly toward the first shell half 200 and an engagement section 122 projecting transversely from the resilient section 121 along a direction opposite to the detachment direction S.

In addition, the engagement section 112 of the upper hook 11 has an upper engagement face 1121 and a lower guiding face 1122. The engagement section 122 of the lower hook 12 has a lower engagement face 1221 and an upper guiding face 1222, wherein the upper engagement face 1121 is generally configured as planar or barbed configuration in order to provide stability during engagement of the upper and lower hooks 11, 12 while the lower and upper guiding faces 1122, 1222 are designed to be inclined in order to minimize the exert force during engagement of the upper and lower hooks 11, 12.

The top post 13 projects perpendicularly from the first side 21 of the first shell half 200 in such a manner to abut against the lower hook 12 during engagement of the upper and lower hooks 11, 12, thereby preventing relative wobbling of the upper and lower hooks 11, 12.

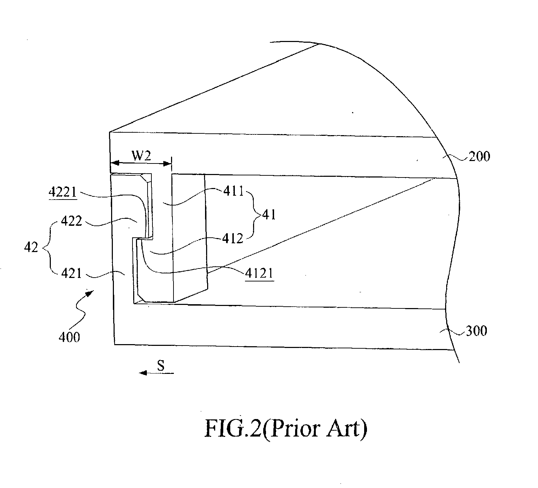

Referring to Figure 2, another embodiment of a conventional coupling structure 400 is disposed between a first shell half 200 and a second shell half 300 for coupling the same into a shell, and includes an upper hook 41 and a lower hook 42. The first and second shell halves 200, 300 are juxtaposed to each other. Each of the upper and lower hooks 41, 42 includes a resilient section 411, 421 and an engagement section 412, 422 excluding the top post. Note the longitudinal lengths of the upper and lower hooks 41, 42 are designed to complement with the distance between and abut tightly against the first and second shell halves 200, 300 once the upper and lower hooks 41, 42 engage each other, thereby providing a stability of the shell.

Note that in the above-mentioned coupling structures, engagement of the upper and lower hooks 11, 41, 12, 42 results in coupling of the first and second shell halves 200, 300. Thus, the upper engagement face 1121, 4121 and the lower engagement face 1221, 4221 are only designed in planar and barbed configuration so that during detachment of the lower hooks 12, 42 along the detachment direction, the upper and lower hooks 11, 41, 12, 42 can not easily detach from each other and resulting in broken occurrence of the upper and lower hooks 11, 41, 12, 42.

In addition, during the coupling or detachment operations, the resilient sections 111, 411, 121, 421 respectively bend along the detachment and opposite directions. Thus, when the conventional coupling structures 100, 400 couple the first and second shell halves 200, 300, the upper and lower hooks 11, 41, 12, 42 cooperatively occupy a relatively large width W1, W2, and a resilient space should be reserved to permit bending of the upper and lower hooks 11, 41, 12, 42, which, in turn, minimizes the circuit receiving space of the shell for layout of the printed circuit board and the electronic components.

### SUMMARY OF THE INVENTION

Therefore, the object of the present invention is to provide a coupling structure for use in a shell that is free of the disadvantages, that includes hooks that bend in direction parallel to a horizontal side of the shell and that needs no barb configuration of the hooks.

The coupling structure according to the present invention is used for coupling first and second shell halves juxtaposed to each other, and includes first and second hooks mounted to the first shell half and a two-way securing hook mounted to the second shell half. The first shell half has a first side. The first hook includes a first resilient section extending from the first side of the first shell half towards the second shell half and a first clamping section extending laterally from the first resilient section along a first direction. The second hook includes a second resilient section extending from the first side of the first shell half towards the second shell half and a second clamping section extending laterally from the second resilient section along a second direction opposite to the first direction. The first and second hooks and the first shell half cooperatively define a clamping space thereamong. The second shell half has a first side. The two-way securing hook includes a securing section projecting from the first side of the second shell half towards the first shell half, a first interfering section extending laterally from the securing section along the second direction and a second interfering section extending laterally from the securing section along the first direction.

When an external force is applied onto the second shell half in a first applied direction so as to move toward the first shell half, the first and second interfering sections respectively abut against the first and second clamping sections so as to cause the first and second hooks bend outwardly and laterally away from each other, thereby temporarily enlarging the clamping space to permit extension of the first and second interfering sections into the clamping space.

When another external force is applied onto the second shell half in a second applied direction opposite to the first applied second direction, the first and second interfering sections respectively abut against the first and second clamping sections so as to cause the first and second hooks bend outwardly and laterally away from each other, thereby temporarily enlarging the clamping space to permit extension of the first and second interfering sections from the clamping space to an exterior of the clamping space.

In the present embodiment, the first clamping section is tapered gradually from the first resilient section along the first direction while the second clamping section is tapered gradually from the second resilient section along the second direction. The first clamping section has an inner inclined face proximate to the first shell half and an outer inclined face distal to the first shell half. The second clamping section has an inner inclined face proximate to the first shell half and an outer inclined face distal to the first shell half.

Preferably, the first interfering section is tapered gradually from the securing section of the two-way securing hook along the second direction while the second interfering section is tapered gradually from the securing section of the two-way securing hook along the first direction.

The first side of the first shell half is formed with at least two peripheral notches respectively adjacent to the first and second hooks and respectively opposite to the clamping space so as to enhance resiliency of the first and second hooks.

When the coupling structure of the present invention is compared to the prior art ones, the present coupling structure is used for coupling the first and second shell halves, and includes first and second hooks mounted to the first shell halves for clamping securely the two-way securing hook of the second shell half. Since the first and second hooks respectively have inner inclined face unlike to that of the prior barbed configuration, it is easy to detach the first and second shell halves.

Since the outwardly and laterally bending of the first and second hooks in the present coupling structure is along a direction parallel to the horizontal side of the first and second shell halves, the first and second hooks in fact occupy a relatively small space of the circuit receiving space of the shell, which, in turn, provides a relatively large space in the shell for layout of printed circuit or electronic components within the shell, in which the coupling structure of the present invention is implemented.

In addition, the peripheral notches formed along the first side of the first shell half respectively adjacent to the clamping space provide enhanced resiliency of the first and second hooks, thereby preventing untimely broken of the first and second hooks.

### BRIEF DESCRIPTION OF THE DRAWINGS

Other features and advantages of this invention will become more apparent in the following detailed description of the preferred embodiments of this invention, with reference to the accompanying drawings, in which:

Figure 1 shows one embodiment of a conventional coupling structure for coupling first and second shell halves into a shell;

Figure 2 shows another embodiment of a conventional coupling structure for coupling first and second shell halves into a shell;

Figure 3 shows a preferred embodiment of a coupling structure of the present invention prior to coupling first and second shell halves into a shell; and

Figure 4 illustrates the preferred embodiment of the coupling structure of the present invention coupling the first and second shell halves into a shell.

### DETAILED DESCRIPTION OF THE PREFERRED EMBODIMENT

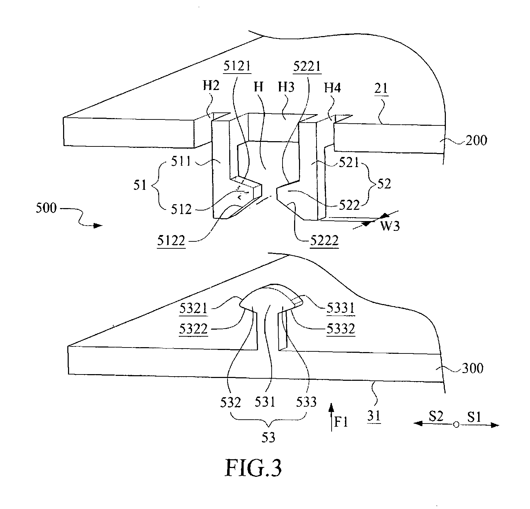

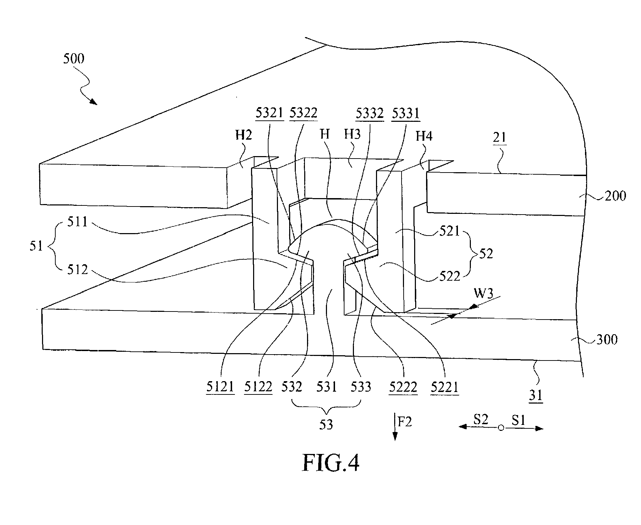

Referring to Figures 3 and 4, wherein Figure 3 shows a preferred embodiment of a coupling structure of the present invention prior to coupling first and second shell halves into a shell while Figure 4 illustrates the preferred embodiment of the coupling structure of the present invention coupling the first and second shell halves into a shell. As shown, the coupling structure 500 of the present invention is disposed between the first and second shell halves 200, 300 juxtaposed to each other for coupling the same into the shell, and includes a first hook 51, a second hook 52 and a two-way securing hook 53. The first shell half 200 has a first side 21. The first hook 51 includes an elongated first resilient section 511 extending from the first side 21 towards the second shell half 300 and a first clamping section 512 extending laterally from the first resilient section 511 along a first direction S1.

The second hook 52 includes an elongated second resilient section 521 extending from the first side 21 of the first shell half 200 towards the second shell half 300 and a second clamping section 522 extending laterally from the second resilient section 522 along a second direction S2 opposite to the first direction S1. The first and second hooks 51, 52 and the first shell half 200 cooperatively define a clamping space H thereamong;

The second shell half 300 has a first side 31. The two-way securing hook 53 includes an elongated securing section 531 projecting from the first side 31 of the second shell half 300 towards the first shell half 200, a first interfering section 532 extending laterally from the securing section 531 along the second direction S2 and a second interfering section 533 extending laterally from the securing section 531 along the first direction S1.

When an external force is applied onto the second shell half 300 in a first applied direction F1 (see Fig. 3) so as to move toward the first shell half 200, the first and second interfering sections 532, 533 respectively abut against the first and second clamping sections 512, 522 so as to cause the first and second hooks 51, 52 bend outwardly and laterally away from each other, thereby temporarily enlarging the clamping space H to permit extension of the first and second interfering sections 532, 533 into the clamping space H and securing the two-way securing hook 53 within the clamping space H, hence coupling the first and second halves 200, 300 into a shell or shell body.

In the same manner, when another external force is applied onto the second shell half 200 in a second applied direction F2 (see Figure 2) opposite to the first applied second direction F1, the first and second interfering sections 532, 533 respectively abut against the first and second clamping sections 512, 522 so as to cause the first and second hooks 51, 52 bend outwardly and laterally away from each other, thereby temporarily enlarging the clamping space H to permit extension of the first and second interfering sections 512, 522 from the clamping space H to an exterior of the clamping space H and releasing the two-way securing hook 53 from the clamping space H, hence separating the first and second halves 200, 300 relative to each other.

As described above, unlike to the conventional coupling structures 100, 400, in the present embodiment, during the detachment operation, the first and second hooks 51, 52 of the coupling structure 500 of the present invention bend outwardly and laterally in a direction parallel to the first sides 21, 31 of the first and second shell halves 200, 300. Thus, the coupling structure 500 of the present invention occupies a space equivalent to the width of the first and second hooks 51, 52 or the width W3 of the securing hook 53. The temporarily bending of the first and second hooks 51, 52 during fastening or detachment operations does not occupy the internal circuit receiving space of the shell, thereby providing a larger internal circuit receiving space when compared to the prior art ones.

In order to provide an ideal operation and enduring effect, the first clamping section 512 of the first hook 51 is tapered gradually from the first resilient section 511 along the first direction S1, and has an inner inclined face 5121 proximate to the first shell half 200 and an outer inclined face 5122 distal to the first shell half 200 and coinciding with the inner inclined face 5121 to form a pointed end. In the same manner, the second clamping section 522 of the second hook 52 is tapered gradually from the second resilient section 521 along the second direction S2, and has an inner inclined face 5221 proximate to the first shell half 200 and an outer inclined face 5222 distal to the first shell half 200 and coinciding with the inner inclined face 5221 to form a pointed end.

Moreover, the first interfering section 532 is tapered gradually from the securing section 531 of the two-way securing hook 53 along the second direction S2 while the second interfering section 533 is tapered gradually from the securing section 531 of the two-way securing hook along the first direction S1. The first and second interfering sections 532, 533 respectively have curved insert faces 5321, 5331 for abutting slidably against the outer inclined faces 5122, 5222 of the first and second hooks 51, 52 during extension of the two-way securing hook 53 into the clamping space H, thereby facilitating insertion of the securing hook 53 into the clamping space H. In the same manner, the first and second interfering sections 532, 533 further respectively have pulled-out faces 5322, 5332 for slidably abutting against the inner inclined faces 5121, 5221 of the first and second hooks 51, 52 during removal of the two-way securing hooks 53 from the clamping space H to an exterior of the clamping space H, thereby facilitating removal of the securing hook 53 from the clamping space H, hence disengaging the first and second shell halves 200, 300.

An important aspect to note is that in the coupling structure 500 of the present invention, the first and second clamping sections 512, 522, the first and second interfering sections 532, 533 are not subjected to simultaneously possess the inner and outer inclined faces 5121, 5221, 5122, 5222 or the insert faces 5321, 5331 and the pulled-out faces 5322, 5332. For insertion operation of the securing hook 53 into the clamping space H, only the outer inclined face 5122, 5222 or the curved insert faces 5321, 5331 are required. For removal of the securing hook 53 from the clamping space H, only the inner inclined faces 5121, 5221 or the pulled-out faces 5322, 5332 are required.

Another aspect to note is that in the present embodiment, the first side 21 of the first shell half 200 is formed with at least two peripheral notches H2, H4 respectively adjacent to the first and second hooks 51, 52 and respectively opposite to the clamping space H so as to enhance resiliency of the first and second hooks 51, 52 during the bending operations while inserting or removing the securing hook 53 into the clamping space H, thereby preventing untimely broken of the first and second hooks 51, 52, hence providing prolonged used of the shell body.

While the invention has been described in connection with what is considered the most practical and preferred embodiments, it is understood that this invention is not limited to the disclosed embodiments but is intended to cover various arrangements included within the spirit and scope of the broadest interpretation so as to encompass all such modifications and equivalent arrangements.

## Claims

1. A coupling structure (500) for coupling first and second shell halves (200, 300) juxtaposed to each other, **characterized by**:
first and second hooks (51, 52) mounted to the first shell half (200) and a two-way securing hook (53) mounted to the second shell half (300), wherein the first shell half (200) has a first side (21) and wherein said first hook (51) includes a first resilient section (511) extending from the first side (21) towards the second shell half (300) and a first clamping section (512) extending laterally from said first resilient section (511) along a first direction (S1);
said second hook (52) including a second resilient section (521) extending from the first side (21) of the first shell half (200) towards the second shell half (300) and a second clamping section (522) extending laterally from said second resilient section (521) along a second direction (S2) opposite to said first direction (S1), wherein said first and second hooks (51, 52) and the first shell half (200) cooperatively define a clamping space (H) thereamong;
the second shell half (300) having a first side (31), said two-way securing hook (53) including a securing section (531) projecting from the first side (21) of the second shell half (300) towards the first shell half (200), a first interfering section (532) extending laterally from said securing section (531) along said second direction (S2) and a second interfering section (533) extending laterally from said securing section (531) along said first direction (S1): and
said first clamping section (512) having an inner inclined face (5121) proximate to said first shell half (200) and an outer inclined face (5122) distal to said first shell half (200), said second clamping section (522) having an inner inclined face (5221) proximate to said first shell half (200) and an outer inclined face (5222) distal to said first shell half (200);
wherein, when an external force is applied onto the second shell half (300) in a first applied direction (F1) so as to move toward the first shell half (200), said first and second interfering sections (532, 533) respectively abut against said first and second clamping sections (512, 522) so as to cause said first and second hooks (51, 52) bend outwardly and laterally away from each other, thereby temporarily enlarging said clamping space (H) to permit extension of said first and second interfering sections (532, 533) into said clamping space (H);
wherein, when another external force is applied onto the second shell half (300) in a second applied direction (F2) opposite to said first applied second direction (S2), said first and second interfering sections (532, 533) respectively abut against said first and second clamping sections (512, 522) so as to cause said first and second hooks (51, 52) bend outwardly and laterally away from each other, thereby temporarily enlarging said clamping space (H) to permit extension of said first and second interfering sections (532, 533) from said clamping space (H) to an exterior of said clamping space.

2. The coupling structure (500) as defined in claim 1, wherein said first clamping section (512) is tapered gradually from said first resilient section (511) along said first direction (S1) while said second clamping section (522) is tapered gradually from said second resilient section (521) along said second direction (S2).

3. The coupling structure (500) as defined in claim 2, wherein said first clamping section (512) has an inner inclined face proximate to said first shell half (200) and an outer inclined face distal to said first shell half (200), said second clamping section (522) having an inner inclined face proximate to said first shell half (200) and an outer inclined face distal to said first shell half (200).

4. The coupling structure (500) as defined in claim 1, wherein said first interfering section (532) is tapered gradually from said securing section (531) of said two-way securing hook (53) along said second direction (S2) while said second interfering section (533) is tapered gradually from said securing section (531) of said two-way securing hook (53) along said first direction (S1).

5. The coupling structure (500) as defined in claim 1, wherein the first side (21) of the first shell half (200) is formed with at least two peripheral notches (H2, H4) respectively adjacent to said first and second hooks (51, 52) and respectively opposite to said clamping space (H) so as to enhance resiliency of said first and second hooks (51, 52).

## Patentansprüche

1. Eine Kopplungsstruktur (500) zum Koppeln von ersten und zweiten Schalenhälften (200, 300), die einander gegenübereinander liegen,
charakterisiert durch:
erste und zweite Haken (51, 52), die an der ersten Schalenhälfte (200) angebracht sind, und ein Zwei-Wege-Sicherungshaken (53), der an der zweiten Schalenhälfte (300) angebracht ist, wobei die erste Schalenhälfte (200) eine erste Seite (21) hat, und wobei der erste Haken (51) einen einen ersten elastischen Abschnitt (511) beinhaltet, der von der ersten Seite (21) bis zur zweiten Schalenhälfte (300) reicht, und einen ersten Klemmabschnitt (512), der sich seitlich von dem genannten ersten elastischen Abschnitt (511) entlang einer erste Richtung (S1) erstreckt;
der besagte zweite Haken (52), einschließlich eines zweiten elastischen Abschnitts (521), der sich von der ersten Seite (21) der ersten Schalenhälften (200) in Richtung auf eine zweite Schalenhälfte (300) und ein zweiter Klemmabschnitt (522), der sich seitlich von dem genannten zweiten elastischen Abschnitt (521) entlang einer erste Richtung (S2) entgegen der besagten ersten Richtung (S1) erstreckt, wobei besagte erste und zweite Haken (51, 52) und die erste Schalenhälfte (200) zusammenwirkend einen Klemmraum (H) beschreiben;
die zweite Schalenhälfte (300) verfügt über eine erste Seite (31), wobei besagter Zwei-Wege-Sicherungshaken (53) einen Sicherungsabschnitt (531) beinhaltet, der aus der ersten Seite (21) der zweiten Schalenhälfte (300) in Richtung der ersten Schalenhälfte (200) vorsteht, außerdem einen interferierenden Abschnitt (532), der sich seitlich von dem besagten Sicherungsabschnitt (531) entlang der besagten zweiten Richtung (S2) erstreckt, und einen zweiten interferierenden Abschnitt (533), der sich seitlich von besagtem Sicherungsabschnitt (531) entlang der besagten ersten Richtung (S1) erstreckt;
und außerdem verfügt der besagte erste Klemmabschnitt (512), über eine innere geneigte Fläche (5121) in der Nähe der besagten ersten Schalenhälfte (200) und eine äußere geneigte Fläche (5222) entfernt von besagter erster Schalenhälfte (200), wobei besagter zweiter Klemmabschnitt (522) über eine innere geneigte Seite (5221) in der Nähe der besagten ersten Schalenhälfte (200) und eine äußere geneigte Seite (5222) entfernt von der ersten Schalenhälfte (200)verfügt;
wobei im Falle, dass eine externe Kraft auf die zweite Schalenhälfte (300) in eine erste ausgeübte Richtung (F1) ausgeübt wird, um diese zur ersten Schalenhälfte (200) hin zu bewegen, besagte erste und zweite interferierende Abschnitte (532, 533) jeweils an besagtem ersten und zweiten Klemmabschnitt (512, 533) anliegen, um dafür zu sorgen, dass besagter erster und zweiter Haken (51, 52) sich nach außen und seitwärts weg von einander biegen, um dadurch zeitweilig den Klemmraum (H) zu vergrößern, um eine Erweiterung der besagten ersten und zweiten interferierenden Abschnitte (532, 533) in besagten Klemmraum (H) hinein zu erbringen;
wobei im Falle, dass eine andere externe Kraft auf die zweite Schalenhälfte (300) in einer zweiten ausgeübte Richtung (F2) entgegen der besagten ersten ausgeübten zweiten Richtung (S2) ausgeübt wird, liegen besagte erste und zweite interferierende Abschnitte (532, 533) jeweils an besagtem ersten und zweiten Klemmabschnitt (512, 533)an, um dafür zu sorgen, dass besagter erster und zweiter Haken (51, 52) sich nach außen und seitwärts weg von einander biegen, um dadurch zeitweilig den Klemmraum (H) zu vergrößern, um eine Erweiterung der besagten ersten und zweiten interferierenden Abschnitte (532, 533) aus besagtem Klemmraum (H) hinaus zu erbringen.

2. Die Kupplungsstruktur (500) wie in Anspruch 1 definiert, wobei sich der besagte erste Klemmabschnitt (512) schrittweise von besagtem ersten elastischen Abschnitt (511) her verjüngt, und zwar entlang der ersten Richtung (S1), während der besagte zweite Klemmabschnitt (522) sich schrittweise von besagtem zweiten elastischen Abschnitt (521) entlang der besagten zweiten Richtung (S2) verjüngt.

3. Die Kupplungsstruktur (500) wie in Anspruch 2 definiert, wobei der besagte erste Klemmabschnitt (512) eine innere geneigte Seite in der Nähe der besagten Schalenhälfte (200) und eine äußere geneigte Seite entfernt von besagter erster Schalenhälfte (200) hat, und wobei der besagte zweite Klemmabschnitt (522) eine innere geneigte Seite in der Nähe der besagten Schalenhälfte (200) und eine äußere geneigte Seite entfernt von besagter erster Schalenhälfte (200) hat.

4. Die Kupplungsstruktur (500) wie in Anspruch 1 definiert, wobei der erste interferierende Abschnitt (532) sich schrittweise von dem besagten Sicherungsabschnitt (531) des besagten Zwei-Wege-Sicherungshaken (53) her verjüngt, und zwar entlang der besagten zweiten Richtung (S2), während sich der zweite interferierende Abschnitt (531) des besagten Zwei-Weg-Sicherungshakens (53) entlang der ersten Richtung (S1) erstreckt.

5. Die Kupplungsstruktur (500) wie in Anspruch 1 definiert, wobei die erste Seite (21) der ersten Schalenhälfte (200) mit mindestens zwei peripheren Kerben (H2, H4) geformt wird, die jeweils an den besagten ersten und zweiten Haken (51, 52) anliegen und jeweils dem besagten Klemmraum (H) gegenüberliegen, um die Elastizität der besagten ersten und zweiten Haken (51, 52) zu verbessern.

## Revendications

1. Une structure d'accouplement (500) pour l'accouplement de la première et la deuxième moitié de la shell (200, 300) juxtaposées l'une à côté de l'autre, **caractérisée par** :
Le premier et le deuxième crochets (51,52) montés à la première moitié de la shell (200) et une fixation bi-directionnelle du crochet (53) monté à la deuxième moitié de la shell (300), où la première moitié de la shell (200) a un premier côté (21) et où ledit premier crochet (51) inclut une première section résiliente (511) prolongeant le premier côté (21) vers la deuxième moitié de la shell (300) et une première section de retenue (512) se prolongeant latéralement de la dite première section resiliente (511) le long d'une première direction (S1) ;
ledit deuxième crochet (52), y compris une deuxième section résistante (521) s'étendant du premier côté (21) de la première moitié de shell (200) vers la deuxième moitié de shell (300) et une deuxième section de shell et une deuxième section de serrage (522) s'étendant latéralement de ladite deuxième section résiliente (521) le long d'une deuxième direction (S2) en face de ladite première direction (S1), dans laquelle lesdits premier et deuxième crochets (51, 52) et la première moitié de shell (200) définit en collaboration un espace de serrage (H) là parmi ;
la deuxième demie shell (300) ayant un premier côté (31), ledit crochet de fixation bi-directionnel (53) comprenant une section de fixation (531) projetant du premier côté (21) de la deuxième moitié de shell (300) vers la première demie shell (200) , une première section d'interférence (532) se prolongeant latéralement de ladite section de fixation (531) le long de ladite deuxième direction (S2) et une deuxième section d' interférences (533) se prolongeant latéralement de ladite section de fixation (531) le long de ladite première direction (S1) ; et
ladite première section de retenue (512) ayant une face intérieure inclinée (5121) proche à ladite première demie shell (200) et une face inclinée (5122) éloignée de ladite première demie-(200), dite deuxième section de retenue (522) ayant une face intérieure inclinée (5221) proche de la dite première demie- shell (200) et une face inclinée externe (5222) éloignée de ladite première moitié (200) de la shell;
où, quand une force externe est appliquée sur la deuxième demie-shell (300) dans une première direction appliquée (F1) afin de se déplacer vers la première demie shell (200) , les dites première et deuxième sections d'interférences indiquées d'abord et en second lieu s'y mêlant sections (532, 533) respectivement au sujet en contre de ladite première et seconde section de retenue (512,522) afin de causer lesdits premier et deuxième crochets (51,52) courber vers l'extérieur et latéralement loin de l'autre, ainsi temporairement agrandissant ledit espace de serrage (H) pour permettre la prolongation des dites première et deuxième sections d'interférences (532,533) dans ledit espace de serrage (H) ;
où, quand une autre force externe est appliquée sur la deuxième demie shell (300) dans une deuxième direction appliquée (F2) en face de ladite première deuxième direction appliquée (S2), dites première et deuxième sections intervention (532,533) respectivement buter contre lesdites première et deuxième sections de serrages (512,522) afin de provoquer lesdits premier et deuxième crochets (51,52) courber vers l'extérieur et latéralement loin entre eux, agrandissant de ce fait temporairement dit espace de serrage (H) pour laisser l'extension des dites première et deuxième sections d'interférences (532,533) dudit espace de serrage (H) à un extérieur dudit espace de serrage.

2. La structure d'accouplement (500) comme définie dans la réclamation 1, où ladite première section de retenue (512) est ruban rouge graduellement desdites premières sections résilientes (511) le long de ladite première direction (S1) tandis que ladite deuxième section de serrage (522) est effilée graduellement de la dite deuxième section résiliente (521) le long de ladite deuxième direction (S2).

3. la structure d'accouplement (500) comme définie dans la déclarations 2, où ladite première section de retenue (512) a une face inclinée intérieur proche à ladite première shell demie de (200) et une face inclinée externe éloignée de ladite première demie shell (200) , la dite deuxième section de serrage (522) ayant une face intérieure inclinée proche à ladite première demie shell (200) et une face externe inclinée eloignée de dite première demie shell externe distal à ladite première demie shell de (200).

4. La structure d''accouplement (500) comme définis dans la réclamation 1, où la dite première section d'interférences (532) est progressivement effilée de ladite section de fixation (531) de ladite fixation bidirectionnelle.de crochet (53) le long de ladite deuxième direction (S2) pendant la deuxième section section (533) est effilée graduellement de ladite fixation de la section (531) dudit crochet de fixation bi-directionnel (53) le long de ladite première direction (S1).

5. La structure d'accouplement (500) comme définie dans la déclaration 1, où le premier côté (21) de la première demie shell (200) est formé avec au moins deux entailles périphériques (H2,H4) respectivement adjacentes aux premier et deuxième crochets (51, 52) et respectivement opposées au dit espace de serrage (H), afin de d'améliorer la résilience desdits premier et deuxième crochets (51,52).
